# EUROPEAN PATENT APPLICATION

(11) **EP 3 109 265 A1**
(43) Date of publication of application: **28.12.2016**
(21) Application number: 15173363.1
(22) Date of filing: 23.06.2015
(51) Int. Cl.: C08F 12/32, C08J 5/18, C09D 125/16, C09J 125/16, H01L 27/06, C08F 212/08

(54) **SURFACE REACTIVE CROSSLINKABLE COPOLYMERS**

(71) Applicant: Henkel AG & Co. KGaA, 40589 Düsseldorf (DE)
(72) Inventor: SCHÖNFELD, Rainer, 40627 Düsseldorf (DE); FREY, Holger, 79312 Emmendingen (DE); LEIBIG, Daniel, 55118 Mainz (DE)

(57) **Abstract**

The present application is directed to a crosslinkable copolymer comprising styrene and 4-vinyl benzocyclobutene monomers and at least one alkoxysilane group, a method for generating an ultrathin copolymer film, which contains at least one crosslinked copolymer as defined herein, on a silicon-containing substrate, a composition or film comprising at least one copolymer as defined herein, as well as the use of this copolymer or composition containing it for electrical insulation and/or bonding of silicon-containing substrates.

## Description

### Technical field

The present invention is directed to a crosslinkable copolymer comprising styrene and 4-vinylbenzocyclobutene monomers and at least one alkoxysilane group, a method for generating an ultrathin copolymer film, which contains at least one crosslinked copolymer as defined herein, on a silicon-containing substrate, a composition or film comprising at least one copolymer as defined herein, as well as the use of this copolymer or composition containing it for electrical insulation and/or bonding of silicon-containing substrates.

### Background of the invention

Three-dimensional integrated circuits (3D-IC) such as fine wire chips are made of electronic components that are horizontally and vertically integrated in several layers so that they form circuits. As these are arranged compactly, these electronic devices are space saving and are due to the shorter electric connections powerful and less susceptible to interference than conventional circuits. Through silicon-vias (TSV) are electronic connections led through channels with a diameter of 100 nm or less of silicon-containing substrates, which are particularly used in three-dimensional arrangements of chips. In order to prevent current and voltage changes, these connections need to be electrically insulated. In these arrangements, adhesives, which are for example polyimide- or benzocyclobutene-based adhesives, are used to bound silicon-containing substrates together. The adhesives are applied on these substrates either as adhesive films or from a solution by spin coating. However, ultra-thin electrically insulating layers or films with a thickness of less than 10 nm, which are moreover holohedral and uniform, in particular on the inner walls of channels with a diameter in nanometer scale, and bonding of silicon-containing substrates still represents a challenge.

Consequently, there is need for methods and polymers providing for a uniform, holohedral and electrically insulating layer or film having a thickness of less than 10 nm.

### Summary of the invention

In a first aspect, the present invention is thus directed to a copolymer of Formula 1 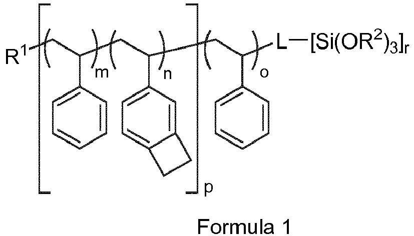 wherein
R¹ is H or a linear or branched alkyl with 1 to 10 C-atoms;
each R² is independently a linear or branched alkyl with 1 to 10 C-atoms;
L is a linear or branched alkylenyl with 1 to 20 C-atoms, a linear or branched alkenylenyl or alkynylenyl with 2 to 20 C-atoms, an arylene or a heteroarylene with 5 to 14 C-atoms or - R'-X-R'-, wherein each R' is independently selected from the group consisting of linear or branched alkylenyl with 1 to 10 C-atoms, a linear or branched alkenylenyl or alkynylenyl with 2 to 20 C-atoms, arylene or heteroarylene with 5 to 14 C-atoms, wherein X is O, S, or NH;
each m is independenty 0 or an integer from 1 to 5;
each n is independently an integer from 1 to 5;
o is 0 or 1;
p is an integer from 2 to 100.000; and
r is an integer from 1 to 5.

In a further aspect, the present invention is directed to an adhesive or coating composition comprising the copolymers described herein.

In a still further aspect, the present invention relates to a method for generating a film on a silicon-containing substrate comprising the steps of:
(i) applying at least one adhesive or coating composition comprising the crosslinkable copolymer according to the invention onto the surface of a silicon-containing substrate; and
(ii) heating the silicon-containing substrate to a temperature of at least 200 °C to cure the composition and form the film,
   wherein the silicon-containing substrate is preferably a chip or a wafer.

In another aspect, the present invention relates to a film obtainable by a method as disclosed herein.

In a still further aspect, the present invention is directed to the use of a crosslinkable copolymer as disclosed herein or composition containing it for electrical insulation and/or bonding of silicon-containing substrates.

### Detailed description of the invention

In the following passages the present invention is described in more detail. Each aspect so described may be combined with any other aspect or aspects unless clearly indicated to the contrary. In particular, any feature indicated as being preferred or advantageous may be combined with any other feature or features indicated as being preferred or advantageous.

In the context of the present invention, the terms used are to be construed in accordance with the following definitions, unless a context dictates otherwise.

As used herein, the singular forms "a", "an" and "the" include both singular and plural referents unless the context clearly dictates otherwise.

The terms "comprising", "comprises" and "comprised of" as used herein are synonymous with "including", "includes" or "containing", "contains", and are inclusive or open-ended and do not exclude additional, non-recited members, elements or method steps.

The recitation of numerical end points includes all numbers and fractions subsumed within the respective ranges, as well as the recited end points.

When an amount, a concentration or other values or parameters is/are expressed in form of a range, a preferable range, or a preferable upper limit value and a preferable lower limit value, it should be understood as that any ranges obtained by combining any upper limit or preferable value with any lower limit or preferable value are specifically disclosed, without considering whether the obtained ranges are clearly mentioned in the context.

"At least one", as used herein, relates to one or more, preferably 1, 2, 3, 4, 5, 6, 7, 8, 9, 10 or more. It is understood that this term, when used in combination with a material and/or a compound, for example the disclosed copolymer, does not relate to the absolute number of copolymers, but rather to the type of the copolymer used. By way of example only, the term "at least one copolymer" thus means that one or more different copolymer can be used.

All references cited in the present specification are hereby incorporated by reference in their entirety.

Unless otherwise defined, all terms used in the disclosing the invention, including technical and scientific terms, have the meaning as commonly understood by one of the ordinary skill in the art to which this invention belongs to. By means of further guidance, term definitions are included to better appreciate the teaching of the present invention.

Further, the examples contained herein are intended to describe and illustrate the invention and are not intended to limit the invention. The present invention is not limited to these examples. All percentages are, unless otherwise specified, % by weight

The present invention is based on the inventors' surprising finding that a crosslinkable copolymer comprising styrene and 4-vinylbenzocyclobutene monomers and at least one alkoxysilane group provides for uniform holohedral layers having a thickness of less than 10 nm with electrically insulating properties, and adhere strongly to silicon-containing substrates. The obtained layers additionally show high mechanical strength and a long duration due to the generated crosslinking.

By the use of the crosslinkable copolymer as disclosed herein, holohedral and uniform layers with electrically insulating properties and a thickness less of than 10 nm, preferably of 2 to 3 nm, can be generated on silicon-containing substrates. Furthermore, the obtained layer has a high mechanical strength and a high durability due to the crosslinking of the copolymer. The film provided by the inventive copolymer and method allows the isolation of very small areas such as the inner walls of channels in silicon-containing substrates which are used in modern, three-dimensional circuits which can be found in chips. Further, such substrates can be adhered together by these films and more powerful and compact, three-dimensional circuits can thus be obtained.

As mentioned above, the copolymer according to the present invention has the following Formula 1 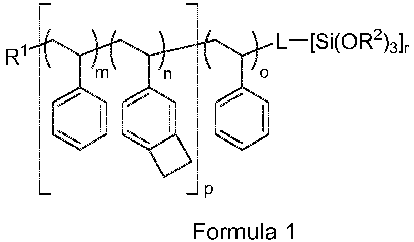 wherein
R¹ is H or a linear or branched alkyl with 1 to 10 C-atoms;
each R² is independently a linear or branched alkyl with 1 to 10 C-atoms;
L is a linear or branched alkylenyl with 1 to 20 C-atoms, a linear or branched alkenylenyl or alkynylenyl with 2 to 20 C-atoms, an arylene or a heteroarylene with 5 to 14 C-atoms or - R'-X-R'-, wherein each R' is independently selected from the group consisting of linear or branched alkylenyl with 1 to 10 C-atoms, a linear or branched alkenylenyl or alkynylenyl with 2 to 20 C-atoms, arylene or heteroarylene with 5 to 14 C-atoms, wherein X is O, S, or NH;
each m is independenty 0 or an integer from 1 to 5;
each n is independently an integer from 1 to 5;
o is 0 or 1;
p is an integer from 2 to 100.000; and
r is an integer from 1 to 5.

The identity of R¹ depends on the type of polymerization used and on the molecule starting the polymerization. The copolymer of the present invention can be obtained by radical polymerization. This type of polymerization can be initiated by a radical initiator or can be initiated photolytically. Therefore, all known radical initiators, which are suitable for this purpose, can be used. Under certain conditions, radical initiators decompose into free radicals and subsequently initiate the polymerization. These radical initiators can be, for example, organic peroxides such as azobis-iso-butyronitrile, diacetyl peroxide, benzoyl peroxide, succinyl peroxide, di-tert-butyl peroxide, tert-butyl peroxybenzoate, cumene hydroperoxid, di-iso-propyl peroxydicarbonate, dicumyl peroxide, tert-butyl iso-butyrate, tert-butyl hydroperoxid, and mixtures thereof. The photolytic polymerization is preferably initiated by high-energy irradiation of the reaction mixture containing the monomers, which have to be suitable for this type of polymerization.

In general, polymerization can be carried out in a temperature range of 0 to 200 °C or from 70 to 140 °C. Optionally, polymerization can be carried out under pressure.

The polymerization can be further carried out in a solvent, such as alcohols, like methanol, ethanol, n-propanol, iso-propanol, n-butanol, sec-butanol, tert-butanol, n-hexanol and cyclohexanol, alkanes and cycloalkanes, such as cyclohexane, heterocycloalkanes, like tetrahydrofuran, as well as glycols, such as propylene glycol, ethylene glycol and butylene glycol, and the methyl or ethyl ethers of dihydric alcohols, and dioxane. In a preferred embodiment, the polymerization is carried out in tetrahydrofuran or cyclohexane.

The copolymer as disclosed herein may be obtained by living radical polymerization techniques, such as the Reversible Addition-Fragmentation chain Transfer polymerization (RAFT), the Nitroxide mediated radical polymerization (NMP) and the Atom Transfer Radical Polymerization (ATRP). The RAFT polymerization of styrene and 4-vinyl benzocyclobutene can be initiated by dithiobenzoates e.g. 2-cyano-2-propyl benzodithioate and 4-cyano-4-(phenylcarbonothioylthio)pentanoic acid or by trithiocarbonates e.g. cyanomethyl dodecyl trithiocarbonate and 2-cyano-2-propyl dodecyl trithiocarbonate. The NMP polymerization of styrene and 4-vinyl benzocyclobutene can be initiated by any alkoxyamine initator e.g. (2,2,6,6-Tetramethyl-piperidin-1-yl)oxyl (TEMPO), which starts the chain growth polymerization at higher temperatures. In addition, the copolymer can be obtained via ATRP polymerization with an alkyl halide initiator, a metal catalyst in presence of nitrogen based ligands e.g. a system like ethyl α-bromo isobutyrate, copper (I) bromide and N,N,N',N",N"-pentamethyldiethyletriamine.

The copolymer as disclosed herein may also be obtained by cationic polymerization. Preferably, the copolymer of the invention is obtained by anionic polymerization. Generally, this type of polymerization has the advantage that the obtained polymers have a very uniform chain length. For such polymerization all known anions, which are suitable for this purpose can be used, including, but not limited to metal amides, such as NaNH₂. In addition, organometallic organyls, such as organolithium and Grignard reagents can be used. According to the present invention, organometallic compounds, preferably organolithium compounds like butyllithium (BuLi) are used. BuLi decomposes into a lithium cation and a butyl carbanion, whereby the later initiates the polymerization. Different isomeres of BuLi can be used, e.g. n-BuLi, sec-BuLi and tert-BuLi which show different reactivities. In a preferred embodiment of the present invention, the isomer sec-BuLi is used for the anionic polymerization.

Consequently, in a preferred embodiment of the present invention, R¹ is a linear or branched alkyl with 2 to 6 C-atoms, preferably with 4 C-atoms, and preferably

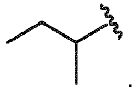

Further, as already mentioned, Grignard compounds are also suitable for the method according to the present invention. These are well known and have the general formula RMgX, wherein R is an organic moiety, preferably a linear or branched alkyl with 1 to 10 C-atoms, and X is a halogen, preferably Br.

In accordance with the present invention, L is substituted with 1 to 5 -[Si(OR²)₃]. In Formula 1, r is therefore 1 to 5.

Each R² is independently a linear or branched alkyl with 1 to 10 C-atoms, preferably 1 to 5 C-atoms, and more preferably 2 C-atoms, i.e. ethyl. In one -[Si(OR²)₃] group, each R² can be the same or different. For example, in one -[Si(OR²)₃] group, one R² can be methyl, another R² can be a branched alkyl having 8 C-atoms, and the third R² can be ethyl. Alternatively, each R² can be the same, e.g. ethyl.

L is attached to a styrene unit, if o is 1, and to a 4-vinylbenzocyclobutene unit, if o is 0. L is a linear or branched alkylenyl with 1 to 20 C-atoms, a linear or branched alkenylenyl or alkynylenyl with 2 to 20 C-atoms, an arylene or a heteroarylene with 5 to 14 C-atoms or - R'-X-R'-. In this connection, each R' is independently selected from the group consisting of linear or branched alkylenyl with 1 to 10 C-atoms, linear or branched alkenylenyl or alkynylenyl with 2 to 10 C-atoms, arylene or heteroarylene with 5 to 14 C-atoms. X, as used herein, is O, S, or NH.

"Alkylenyl" or "alkylene", as interchangeably used herein, means an alkanediyl functional group, such as, without limitation, -CH₂-.

"Alkenylenyl" or "alkenylene", as interchangeably used herein, means an alkenediyl functional group, such as, without limitation, -CH=CH-.

"Alkynylenyl" or "alkynylene", as interchangeably used herein, means an alkynediyl functional group, such as, without limitation, -C=C-.

"Arylene" or "arylenyl", as interchangeably used herein, means an arendediyl group, such as, without limitation phenylene. "Heteroarylene" or "-arylenyl", similarly refers to an heteroarenediyl group.

In a preferred embodiment, L is a linear or branched alkylenyl with 1 to 10 C-atoms, a linear or branched alkenylenyl or alkynylenyl with 2 to 10 C-atoms, an arylene or heteroarylene with 5 to 10 C-atoms or -R'-X-R'-. Each R' is independently selected from the group consisting of linear or branched alkylene with 1 to 5 C-atoms, linear or branched alkenylene or alkynylene with 3 to 5 C-atoms, arylene or heteroarylene with 5 to 10 C-atoms, wherein X is O, S, or NH.

Furthermore, m is 0 to 5, n is 1 to 5, o is 0 or 1 and p is 2 to 100,000. Preferably, p is 5 to 50,000. In all ranges given, m, n, o, p and r are integers or, if included in the respective definition, 0. At each occurrence, each m and each n can be independently selected from the given numbers. In other words, each section p may differ in length and composition depending on how m and n are selected.

According to the present invention, the copolymer can be an alternating copolymer, a statistical copolymer, or a block copolymer. In general, alternating copolymers comprise monomers in alternating sequence and block copolymers are made up of blocks of different (polymerized) monomers, while the distribution of the different blocks of monomers within the polymer is arbitrary. The distribution of the monomer units within the copolymer as well as the length of the resulting copolymer can be adapted to the individual requirements of the polymer according to the invention, method, film, and use. The distribution of the monomer units within a statistical polymer can be illustrated in more detail with reference to an exemplary method as follows: In the first reaction step, styrene and 4-vinylbenzocyclobutene are dissolved in cyclohexane or THF and sec-BuLi is added at one go to start the polymerization. Therefore, the obtained copolymer will have a gradient structure (gradient structure verified by 1 H NMR kinetic studies). If prepolymerized blocks of styrene and 4-vinylbenzocyclobutene monomers are used, a block copolymer is obtained.

In various embodiments, the copolymer according to Formula 1 has a molecular weight of 500 to 100,000 g/mol, preferably of 1000 to 50,000, more preferably of 2,000 to 20,000 g/mol and most preferably of 2500 to 15,000 g/mol. The composition and the sequence of the two monomers can be adapted to the desired properties. The 4-vinylbenzocyclobutene units in the copolymer are subsequently transformed thermolytically into reactive xylylene at about 180 °C which crosslink and form C-C-bonds. This cross-linking provides for a high mechanical strength, resistance and long duration of the formed, crosslinked layer. The molecular weight is measured in three ways: a gel permeation chromatography (GPC) with the eluent THF and a PS standard; 1H NMR end group analysis and MALDI-ToF mass spectrometry. The 4-vinylbenzocyclobutene (4-VBCB) content is examined by ¹H NMR spectroscopy.

At this point it should be noted that all embodiments disclosed above in connection to the copolymer of Formula 1, in particular the molecular weight, the distribution and the number of monomer units in a copolymer, the values of m, n, and o, the type of polymerization initiators, are similarly applicable to the copolymers of Formulas 2 and 3 and the copolymers of Formula (I) and (II), as defined below.

In another aspect of the present invention, the copolymer has the Formula 2

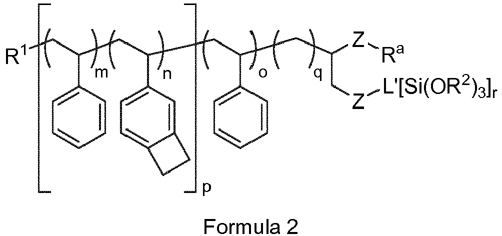

In this case, R¹ is H or a linear or branched alkyl with 1 to 10 C-atoms and in a preferred embodiment, R¹ is a branched alkyl group with 2 to 6 C-atoms, preferably a linear or branched alkyl with 4 C-atoms, more preferably

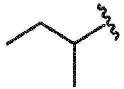

In Formula 2, R^{a} is H, a linear or branched alkyl with 1 to 20 C-atoms, a linear or branched alkenyl or alkynyl with 3 to 20 C-atoms, an aryl or a heteroaryl with 5 to 14 C-atoms. R^{a} is further optionally substituted with 1 to 5 Si(OR²)₃. Consequently, r in Formula 2 is 1 to 5. In another preferred embodiment, R^{a} is a linear or branched alkyl with 1 to 10 C-atoms, preferably 1 to 5 C-atoms, more preferably 1 to 3 C-atoms, wherein R² is optionally substituted with 1 to 5 Si(OR²)₃, preferably terminally. Each R² is independently a linear or branched alkyl with 1 to 10 C-atoms. Preferably, each R² is independently an alkyl with 1 to 5 C-atoms, more preferably 2 C-atoms. In Formula 2, each Z is independently O, S, or NH, preferably Z is O.

L' is a linear or branched alkylene with 1 to 20 C-atoms or a linear or branched alkenylene or alkynylene with 2 to 20 C-atoms. L' can also be -R'-X-R'-, wherein each R' is independently selected from the group consisting of linear or branched alkylene with 1 to 10 C-atoms, linear or branched alkenylene or alkynylene with 2 to 10 C-atoms, arylene or heteroarylene with 5 to 14 C-atoms, wherein X is O, S, or NH. L' is substituted with r - [Si(OR²)₃], wherein r is 1 to 5. In a preferred embodiment of the present invention, L' is a linear or branched alkylene with 1 to 10 C-atoms, alkenylene or alkynylene with 2 to 10 C-atoms, preferably alkylene with 1 to 5 C-atoms, preferably 3 C-atoms.

In this context, m is 0 to 5, n is 1 to 5, o is 0 or 1, and p is 2 to 100,000. Preferably, p is 5 to 50,000. In each section formed by p, which may be different or the same, each m and n therein can be different or the same. Further, q is 1 to 10, preferably 1 to 5, and more preferably 1. As described above for the compounds of Formula 1, m, n, o, p, q, r are integers or, if the respective definition includes it, 0.

In yet another aspect of the present invention, the copolymer is of Formula 3 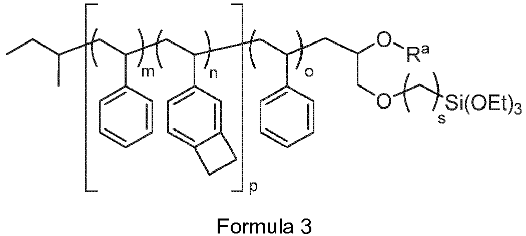 wherein:
R^{a} is an alkyl with 1 to 10 C-atoms, preferably with 1 to 6 C-atoms. Preferably, R^{a} is an alkyl with 3 C-atoms. R^{a} may be optionally substituted with 1 to 5 -Si(OEt)₃, preferably terminally substituted with said siloxane groups. In a preferred embodiment, R^{a} is methyl.

In Formula 3, m is 0 to 5, n is 1 to 5, o is 0 or 1. Further, p is 2 to 100,000, and preferably 5 to 50,000, wherein each of m and n for each p may be independently different. In other words, each section, which may have a different or equal length and is formed by p, each of m and n is same or different. Finally, s is 1 to 10, preferably 1 to 6, and more preferably, s is 3. As described above for the compounds of Formula 1, m, n, o, p, s are integers or, if the respective definition includes it, 0.

The copolymer as disclosed herein may also be a copolymer of Formula (I) or (II) 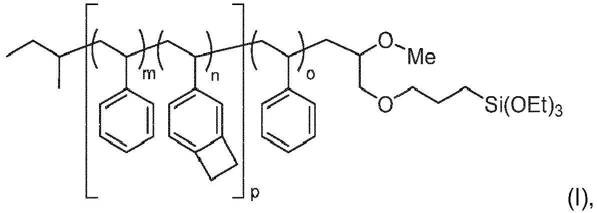 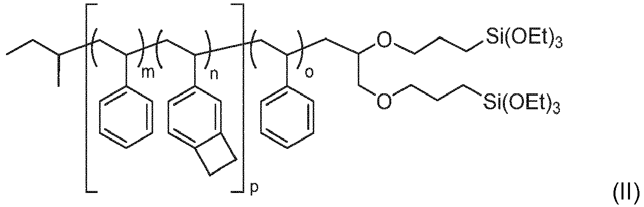 wherein:
m is 0 to 5, n is 1 to 5, o is 0 or 1, and p is 2 to 100,000. Preferably, p is 5 to 50,000. Also in this context, each m and n may be different for each p. In other words, each section which may have a different or equal length and is formed by p, each of m and n is same or different. As described above for the compounds of Formula 1, m, n, o, p are integers or, if the respective definition includes it, 0.

In a further aspect, the present invention is directed to adhesive or coating composition that comprises the copolymers as described above.

The coating compositions may be liquid, preferably in form of a solution or dispersion. For such solutions or dispersions, alkyl halides such as dichloromethane, chloroform and ethylene dichloride, hydrocarbons such as linear alkanes like pentane, hexane, cyclic hydrocarbons such as cyclohexane or aromatic hydrocarbons such as benzene or toluene are suitable solvents. The selection of the solvent depends inter alia on the composition of the copolymer itself, its molecular weight and its concentration in the solution or dispersion.

The concentration of the copolymer in the solution or dispersion can be chosen in a range from 0.0001 to 10 wt%, preferably from 0.05 to 5 wt.%, more preferably 0.01 to 2 wt.%.

Moreover, mixtures of different copolymers can be used in the coating compositions, depending on the requirements of said film, such as insulating properties, layer thickness, etc.

The coating compositions can additionally contain additives and other components typically used for such applications, all of which are well known to those skilled in the art. Such additives include, without limitation, dyes and pigments, fillers, preservatives, stabilizers, and the like.

In another aspect, the invention features a method for generating a film, preferably an electrically insulting film, on a silicon-containing substrate. The method generating a film comprises the steps of:
(i) applying at least one crosslinkable copolymer according to the present invention or composition containing such copolymer as described above onto the surface of a silicon-containing substrate, and
(ii) heating the silicon-containing substrate to a temperature of at least 200 °C to cure the copolymer or composition containing it and form the film,
wherein the silicon-containing substrate is preferably a chip or a wafer.

By this method, ultra-thin, holohedral layers with a thickness of less than 10 nm, e.g. 2 to 3 nm, can be applied on silicon containing substrates. This is particularly advantageous for channels having a diameter of about 100 nm and less, as used in TSV, as these small interior areas of the channels can be coated evenly and completely throughout the polymer. These channels can hence be optimally insulated. Additionally, the applied film is ultra-thin and sufficient space for the electric connections is provided, without choking or blocking the channel which may prevent the generating of the electric connection.

Without wishing to be bound to any particularly theory, it is assumed that the alkoxysilane group of the copolymer reacts with the silicon-containing substrate and forms covalent bonds. Consequently, the more alkoxysilane groups are contained in a copolymer the stronger becomes the covalent bonding between the substrate and the copolymer. The bonding strength of the copolymer is thus adjustable. To achieve this, it is essential that the silicon-containing substrate is able to form -Si-O-Si-bonds. Further, the stability and durability of the film obtained according to the methods of the present invention can be regulated by the amount of 4-vinylbenzocyclobutene monomer units, since the cyclobutene ring undergoes a conrotatory ring-opening reaction upon heating and forms subsequently o-xylylene. This reactive species crosslinks, preferably with each other, and thereby forms C-C-bonds and imparts the film with a high resistance and durability.

A silicon-containing substrate, as referred to herein, can be any suitable silicon-containing substrate. In a preferred embodiment of the present invention, the silicon-containing substrate is a chip or a wafer.

The present invention also relates to a method for generating a film on a silicon-containing substrate. The method according to the present invention comprises two steps. The application step (i) of the method includes application by dipping, spraying, printing, coating, and/or wetting with a composition containing at least one crosslinkable copolymer.

In step (ii) of the method, the silicon-containing substrate on the surface of which the composition comprising the copolymer has been applied is heated to a temperature of at least 200 °C. Upon heating, the copolymer crosslinks (cures) and the bonds between the silicon-containing substrate and the copolymer are formed. It is also possible to use higher temperatures, for example 250 °C or 300 °C. The heating can be conducted by all known methods, techniques, and equipment, such as a furnace or a hot air blower. Depending on the requirements of step (ii), the heating can be performed for a few minutes up to several hours, for example from 1 minute to 72 hours, preferably from 1 minute to 48 hours and, more preferably 10 minutes to 3 hours. Longer heating periods support a more even distribution of the copolymer on the substrate. Optionally, the method and/or individual steps thereof can be carried out several times with the same silicon-containing substrate.

It should be noted that the entire substrate surface can be coated with the copolymer composition (for example in form of a wet film), or alternatively, only parts or small areas of said substrate may be coated.

In another aspect, the present invention relates to a film obtainable by a method as disclosed herein. This film comprises at least one crosslinkable copolymer as disclosed herein, which is crosslinked (cured) during step (ii). Due to the crosslinking, the obtained film has a high mechanical resistance and durability. This film can optionally comprise further substances, in particular additives, which are known in the art and are suitable for this purpose, such as, for example, dyes and/or fillers. These are then typically "crosslinking" as referred to herein, which is tantamount to "curing", the copolymer or film formed thereof.

In still a further aspect, the present invention is directed to the use of at least one crosslinkable copolymer as disclosed herein for insulating and/or bonding of the silicon-containing substrates. The term 'insulate' as used herein means electrically insulating. As mentioned above, in principle all silicon-containing substrates which are suitable for this purpose can be used, however, the substrate is preferably a chip or wafer. The wafer may be, for example, a component of a solar cell. In order to bind the silicon-containing substrates to each other, the methods as described herein are used, whereby after application of said copolymer said to-be-bonded substrates are contacted with each other. Optionally, this can be done by pressing both against each other. The heating in step (ii) is then performed, while said substrates are still in contact, optionally under pressure if required. In such embodiments, the copolymer may be applied to the surface or parts of the surface of only one of the substrates or to the surfaces or parts of the surfaces of both substrates, which will be adhered together.

### Examples

The chemicals used in the examples were obtained from the following suppliers: styrene from Sigma-Aldrich; 4-vinylbenzocyclobutene from Sigma-Aldrich; THF from fisher scientific; sec-BuLi 1.3M solution in Cyclohexane/Hexane (92/8) from Acros Organics; allyl glycidyl ether from Sigma-Aldrich; cyclohexane from fisher scientific; CaH₂ from Acros Organics; toluene from Sigma-Aldrich; chloroform from Sigma-Aldrich; Mel from Sigma-Aldrich; benzene from Sigma-Aldrich; allyl bromide from Sigma-Aldrich; methanol from Sigma-Adlrich; Karstedt-catalyst (Platinum-divinyltetramethyldisiloxane complex in xylene (2.1-2.4%Pt)) from ABCR; TEOS from ABCR; Dichloromethane (Sigma-Aldrich); Chlorobenzene from Acros Organics; potassium naphthalide - KNp - (0.5 M solution in THF; potassium from Acros Organics - naphthalene from Acros Organics and THF from fisher scientific).

### 1a. Synthesis of poly(styrene-co-(4-vinylbenzocyclobutene))-allyl glycidyl ether in tetrahydrofuran

3 mL of styrene (26 mmol) and a spatula tip of CaH₂ were placed in a dry flask and stirred for 1 hour. Then the styrene was degassed and transferred into a flask containing 40 mL dry THF, and subsequently 0.19 g of freshly distilled 4-vinylbenzocyclobutene (1.4 mmol) was added. This mixture was brought to a temperature of -85 °C and under vigorous stirring, 0.6 mL of sec-BuLi in cyclohexane (0.78 mmol 1.3 M) was added. After 1 hour, 0.8 mL of dry and degassed allyl glycidyl ether (6.8 mmol) was added to the mixture, and the mixture was stirred for an additional hour. The solvent was removed in vacuo, and the residue was redissolved in chloroform. The solution was precipitated in methanol. Pure end functionalized polymer was obtained using flash chromatography techniques (silica, eluent: 1. toluene, 2. THF). Table 1 summarizes details including analytical data of two polymers (I) synthesized in THF.

**Table 1.**

| V (styrene) [mL] | V (4-VBCB) [mL] | V (sec-BuLi | Mₙ (GPC) [g mol⁻¹] | Mₙ (¹H-NMR) |
|---|---|---|---|---|
| m (styrene) [g] | m (4-VBCB) [g] | 1.3M) [mL] | M_{w} (GPC) [g mol⁻¹] | [g mol⁻¹] |
| n (styrene) [mmol] | n (4-VBCB) [mmol] | n (*sec*-BuLi1.3M] | PDI (GPC) (PS Standard) | 4-VBCB content [mol%] |
| 3.0 | 0.20 | 0.60 | 4,400 | 4,560 |
| 2.7 | 0.19 | 0.78 | 5,470 | 3.6 |
| 26 | 1.4 | | 1.24 | |
| 1.50 | 0.31 | 0.25 | 6,710 | 6,670 |
| 1.37 | 0.30 | 0.32 | 7,200 | 18 |
| 13.1 | 2.3 | | 1.07 | |

### 1b. Synthesis of poly(styrene-co-(4-vinylbenzocyclobutene))-allyl glycidyl ether in cyclohexane

6.1 mL of styrene (53 mmol) and a spatula tip of CaH₂ were placed in a dry flask and stirred for 1 hour. Then the styrene was degased and transferred into a flask containing 100 mL dry cyclohexane, and subsequently 0.29 g of freshly distilled 4-vinylbenzocyclobutene (2.2 mmol) was added via syringe. This mixture was brought to room temperature, and under vigorous stirring, 0.45 mL of sec-BuLi in cyclohexane (0.58 mmol 1.3 M) was added. After 24 hours, 0.7 mL of dry and degassed allyl glycidyl ether (5.8 mmol) is added to the mixture and this mixture was stirred for an additional hour. The solvent was removed in vacuo and the residue was redissolved in chloroform. The solution was precipitated in methanol. Pure end functionalized polymer was obtained using flash chromatography techniques (silica, eluent: 1. toluene, 2. THF). Table 1 summarizes details including analytical data of four polymers (I) synthesized in cyclohexane.

**Table 2.**

| V (styrene) [mL] | V (4-VBCB) [mL] | V (sec-BuLi 1.3M) [mL] | Mₙ (GPC) [g mol⁻¹] | Mₙ (¹H-NMR) [g mol⁻¹] |
|---|---|---|---|---|
| m (styrene) [g] | m (4-VBCB) [g] | | M_{w} (GPC) [g mol⁻¹] | 4-VBCB content [mol%] |
| n (styrene) [mmol] | n (4-VBCB) [mmol] | n (*sec*-BuLi 1.3M] [mmol] | PDI (GPC) (PS standard) | |
| 3.0 | 0.20 | 0.50 | 6,490 | 6,300 |
| 2.7 | 0.19 | 0.65 | 6,890 | 4.5 |
| 26 | 1.4 | | 1.06 | |
| 1.50 | 0.31 | 0.31 | 7,480 | 7,290 |
| 1.37 | 0.30 | 0,40 | 8,050 | 14 |
| 13.1 | 2.3 | | 1.08 | |
| 6.1 | 0.30 | 0.45 | 11,340 | 10,850 |
| 5.5 | 0.29 | .58 | 11,960 | 3.8 |
| 53 | 2.2 | | 1.05 | |
| 2.0 | 0.60 | 0,17 | 13,600 | 13,300 |
| 1.8 | 0.57 | 0.23 | 14,700 | 20 |
| 17 | 4.4 | | 1.08 | |

### 2. Methylation of the Poly (styrene-co-(4-vinylbenzocyclobutene))-allyl glycidyl ether

2.5 g (0.77 mmol) of poly(styrene-co-(4-vinylbenzocyclobutene))-allyl glycidyl ether were dissolved in dry THF and titrated with potassium naphthalide in THF (0.5 M) until the green colour was maintained. 0.72 mL Mel (12 mmol, 15 eq.) were added with a syringe, subsequently the green colour disappeared and the solution became cloudy. After stirring at room temperature for 1 hour, the solvent was removed under reduced pressure, and the residue was dissolved in chloroform and precipitated twice in methanol. The polymer was dried overnight under high vacuum.

### 3. Allylation of the Poly (styrene-co-(4-vinylbenzocyclobutene))-allyl glycidyl ether

300 mg of poly(styrene-co-(4-vinylbenzocyclobutene))-allyl glycidyl ether were dissolved in 12 ml benzene, and stirred for 1 hour and dried overnight under high vacuum. Subsequently, 40 ml dry THF was added to the polymer *via* cyro-technique. The mixture was stirred while, approximately 0.3 mL of KNp solution (0.5 M in THF) was added dropwise at room temperature until the solution retained green colour. Subsequently, 0.25 mL allyl bromide (0.35 g, 2.9 mmol), which was degassed and dried over CaH₂, was injected into the reaction mixture, which became colourless immediately. The mixture was stirred at RT for 2 hours. Subsequently, the non-reacted allyl bromide and the solvent were removed *in vacuo* and the residue was dissolved in chloroform. The solution was precipitated into methanol and the polymer was dried overnight under high vacuum.

### 4. Hydrosilation of Poly (styrene-co-(4-vinylbenzocyclobutene)) allyl glycidyl ether methyl

100 mg of poly(styrene-co-(4-vinylbenzocyclobutene))-allyl glycidyl ether methyl was dissolved in 4 ml benzene, stirred for 1 h and then dried overnight under high vacuum. In the glove box, the polymer was dissolved in 4 ml of chlorobenzene and one drop of Karstedt catalyst (2% Pt in xylene) was added. In a stream of argon 140 µl TEOS (0.77 mmol) was added and the solution was stirred at 60 °C for 3 days. The excess TEOS and the solvent were removed *in vacuo,* the residue was dissolved in dichloromethane and precipitated from methanol. The obtained solid was dried overnight under high vacuum.

### 5. Hydrosilation of Poly (styrene-co-(4-vinylbenzocyclobutene)) allyl glycidyl ether allyl

100 mg of poly(styrene-co-(4-vinylbenzocyclobutene))-allyl glycidyl ether allyl was dissolved in 4 ml benzene, stirred for 1 hour and then dried overnight under high vacuum. In the glove box, the polymer was dissolved in 4 ml of chlorobenzene and one drop of Karstedt catalyst (2% Pt in xylene) was added. In a stream of argon 285 µl TEOS (1.54 mmol) were added and the solution was stirred at 60 °C for 3 days. The excess TEOS and the solvent were removed *in vacuo,* the residue was dissolved in dichloromethane and precipitated from methanol. The obtained solid was dried overnight under high vacuum.

### 6. Deposition of the copolymer on a silicon-containing substrate

The copolymer was applied to a surface by a silicon wafer, which was previously treated with the RCA method (J. Electrochem. Soc. 1990 volume 137, issue 6, 1887-1892), it was put into a polymer solution with triethylamine for 24 hours on a shaker. The coated silicon element was then heated to 200 °C for 24 hours on the glass transition temperature for a uniform distribution. Finally, the wafer was washed with toluene.

The thickness of the thin polymer films were measured by ellipsometry with the instrument Nanofilm Surface Analysis and by X-ray reflectometry with a Seifert XRD 3003 TT. The roughness of the layer was examined with an atomic force microscope more precisely a MultiMode Pico Scanning Probe Microscope of Veeco Instruments Inc. with a silicon cantilever of Olympus.

## Claims

1. Copolymer of Formula 1 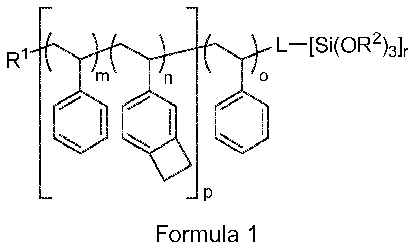 wherein
R¹ is H or a linear or branched alkyl with 1 to 10 C-atoms;
each R² is independently a linear or branched alkyl with 1 to 10 C-atoms;
L is a linear or branched alkylenyl with 1 to 20 C-atoms, a linear or branched alkenylenyl or alkynylenyl with 2 to 20 C-atoms, an arylene or a heteroarylene with 5 to 14 C-atoms or -R'-X-R'-, wherein each R' is independently selected from the group consisting of linear or branched alkylenyl with 1 to 10 C-atoms, a linear or branched alkenylenyl or alkynylenyl with 2 to 20 C-atoms, arylene or heteroarylene with 5 to 14 C-atoms, wherein X is O, S, or NH;
each m is independenty 0 or an integer from 1 to 5;
each n is independently an integer from 1 to 5;
o is 0 or 1;
p is an integer from 2 to 100.000; and
r is an integer from 1 to 5.

2. Copolymer according to claim 1, wherein
(i) R¹ is a linear or branched alkyl with 1 to 6 C-atoms, preferably 4 C-atoms, more
preferably 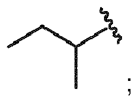 and/or
(ii) each R² is independently a linear or branched alkyl with 1 to 5 C-atoms, preferably ethyl; and/or
(iii) L is a linear or branched alkylenyl with 1 to 10 C-atoms, a linear or branched alkenylenyl or alkynylenyl with 3 to 10 C-atoms, an arylene or a heteroarylene with 5 to 10 C-atoms or -R'-X-R'-, wherein each R' is independently selected from the group consisting of linear or branched alkylenyl with 1 to 5 C-atoms, linear or branched alkenylenyl or alkynylenyl with 3 to 5 C-atoms, arylene or heteroarylene with 5 to 10 C-atoms, wherein X is O, S, or NH; and/or
(iv) p is an integer from 5 to 50,000.

3. Copolymer according to claim 1 or 2 of Formula 2 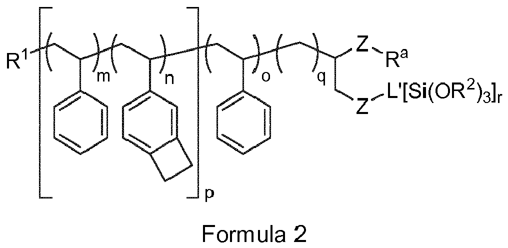 wherein
R¹ is H or a linear or branched alkyl with 1 to 10 C-atoms;
each R² is independently a linear or branched alkyl with 1 to 10 C-atoms; R^{a} is H, a linear or branched alkyl with 1 to 10 C-atoms, alkenyl or alkynyl with 3 to 20 C-atoms, an aryl or a heteroaryl with 5 to 14 C-atoms, wherein R^{a} is optionally substituted with 1 to 5 -Si(OR²)₃;
L' is a linear or branched alkylenyl with 1 to 20 C-atoms, a linear or branched alkenylenyl or alkynylenyl with 3 to 20 C-atoms, or -R'-X-R'-, wherein each R' is independently selected from the group consisting of linear or branched alkylenyl with 1 to 10 C-atoms, a linear or branched alkenylenyl or alkynylenyl with 3 to 10 C-atoms, arylene or heteroarylene with 5 to 14 C-atoms, wherein X is O, S or NH;
each m is independently 0 or an integer from 1 to 5;
each n is independently an integer from 1 to 5;
o is 0 or 1;
p is an integer from 2 to 100.000; and
r is an integer from 1 to 5.

4. Copolymer according to claim 3, wherein
(i) R¹ is a linear or branched alkyl with 1 to 6 C-atoms, preferably 4 C-atoms, more
preferably 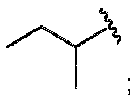 and/or
(ii) R^{a} is a linear or branched alkyl with 1 to 10 C-atoms, preferably 1 to 5 C-atoms, more preferably 1 to 3 C-Atomen, and is optionally substituted with 1 to 5 -Si(OR²)₃, preferably terminally, wherein each R² is independently an alkyl with 1 to 5 C-atoms, preferably ethyl; and/or
(iii) each Z is O; and/or
(iv) L' is a linear or branched alkylenyl with 1 to 10 C-atoms, a linear or branched alkenylenyl or alkynylenyl with 3 to 10 C-atoms, preferably alkylenyl with 1 to 5 C-atoms, more preferably 3 C-atoms; and/or
(v) p is an integer from 5 to 50,000; and/or
(vi) q is an integer from 1 to 10, preferably 1 to 5, more preferably 1.

5. Copolymer according to any one of the claims 1 to 4 of Formula 3 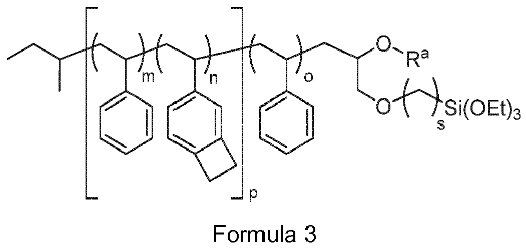 wherein
R^{a} is alkyl with 1 to 10 C-atoms, preferably with 1 to 6 C-atoms, more preferably 3 C-atoms, even more preferred methyl, and is optionally substituted with 1 to 5-Si(OEt)₃, preferably terminally;
each m independently is 0 or an integer from 1 to 5;
each n independently is an integer from 1 to 5;
o is 0 or 1;
p is an integer from 2 to 100,000, preferably 5 bis 50,000; and
s is an integer from 1 to 10, preferably 1 to 6, more preferably 3.

6. Copolymer according to any one of the claims 1 to 5, whereby the copolymer is a copolymer of Formula (I) or (II) 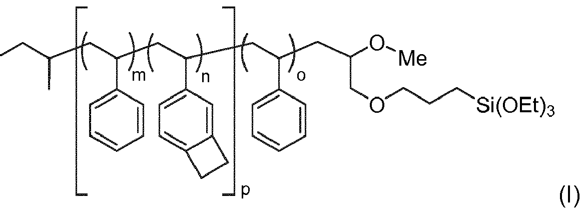 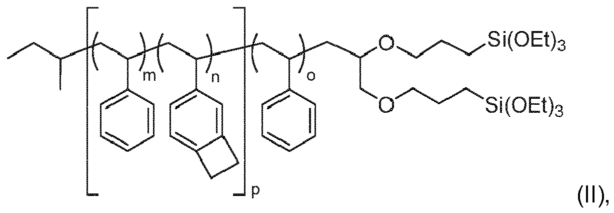 wherein
each m independently is 0 or an integer from to 5;
each n independently is an integer from 1 to 5;
o is 0 or 1; and
p is an integer from 2 to 100,000, preferably 5 to 50,000.

7. Adhesive or coating composition comprising the copolymer of any one of claims 1 to 6.

8. The adhesive or coating composition of claim 7, wherein the composition is a liquid composition, preferably a solution or dispersion comprising the copolymer.

9. Method for generating a film on a silicon-containing substrate, comprising the steps of:
(i) applying the adhesive or coating composition according to claim 7 or 8 onto the surface of a silicon-containing substrate; and
(ii) heating the silicon-containing substrate to a temperature of at least 200 °C to cure the composition and form the film,
wherein the silicon-containing substrate is preferably a chip or a wafer.

10. Film obtainable by a method according to claim 9.

11. Use of at least one copolymer according to one of the claims 1 to 6 or the composition of according to claim 7 or 8 for electrical insulation and/or bonding of silicon-containing substrates, wherein the silicon-containing substrate is preferably a chip or a wafer.
